# EUROPÄISCHE PATENTSCHRIFT

(11) **EP 1 352 423 B1**
(45) Veröffentlichungstag und Bekanntmachung des Hinweises auf die Patenterteilung: **14.07.2010**
(21) Anmeldenummer: 02708151.2
(22) Anmeldetag: 16.01.2002
(51) Int. Cl.: H01L 21/78, H01L 33/00

(54) **VERFAHREN ZUM VEREINZELN VON WAFERN IN CHIPS**
METHOD FOR SUBDIVIDING WAFERS INTO CHIPS
PROCEDE POUR SUBDIVISER DES PLAQUETTES EN PUCES

(30) Priorität: 16.01.2001 DE 10101737
(43) Veröffentlichungstag der Anmeldung: 15.10.2003
(73) Patentinhaber: OSRAM Opto Semiconductors GmbH, 93055 Regensburg (DE)
(72) Erfinder: GÖLTL, Claudia, 92421 Schwandorf (DE); KÜHN, Frank, 81739 München (DE)
(74) Vertreter: Epping - Hermann - Fischer
(86) Internationale Anmeldenummer: PCT/DE2002/000108
(87) Internationale Veröffentlichungsnummer: WO 2002/056365

(56) Entgegenhaltungen:
- US-A- 4 689 125
- US-A- 5 272 114
- US-A- 5 780 320
- PATENT ABSTRACTS OF JAPAN vol. 1997, no. 02, 28. Februar 1997 (1997-02-28) & JP 08 274371 A (TOYODA GOSEI CO LTD), 18. Oktober 1996 (1996-10-18)
- PATENT ABSTRACTS OF JAPAN vol. 014, no. 421 (E-0976), 11. September 1990 (1990-09-11) & JP 02 162750 A (MATSUSHITA ELECTRON CO), 22. Juni 1990 (1990-06-22)
- PATENT ABSTRACTS OF JAPAN vol. 008, no. 206 (E-267), 20. September 1984 (1984-09-20) & JP 59 090940 A (NIPPON DENKI KK), 25. Mai 1984 (1984-05-25)

## Beschreibung

Die Erfindung betrifft ein Verfahren zum Vereinzeln von Wafern in Chips, bei dem der Wafer entlang von Trennungslinien zunächst geschwächt und anschließend gebrochen wird.

Derartige Verfahren sind allgemein bekannt. Üblicherweise wird der Wafer vor dem Brechen angeritzt. Dieses Verfahren ist besonders vorteilhaft, da mit dem Trennvorgang kein Materialverlust verbunden ist. Der Materialverlust wird jedoch nur dann vermieden, wenn ein materialabhängiges Verhältnis von Waferdicke zu Kantenlänge des Chips nicht unterschritten wird. Bei den Verbindungshalbleitern GaAs und InP liegt dieses Verhältnis bei etwa 2 - 2,5 : 1. Wenn diese Grenze unterschritten wird, treten insbesondere Rückseitenausbrüche auf, was die Ausbeute verringert. Falls die Chips verkleinert werden sollen, muß daher auch die Dicke der Chips verringert werden. Kommerziell erhältliche Wafer weisen jedoch vorgegebene Dicken auf, so daß eine Verkleinerung der Längenabmessungen der Chips nur bedingt möglich ist.

In der US 5,272,114 ist ein Verfahren zum Brechen eines Halbleiter-Kriställkörpers offenbart, bei dem Kanäle in dem Kristallkörper ausgebildet werden. Der Kristallkörper wird derart auf eine Weichstoff-Matte oder Gummimatte aufgebracht, dass die Kanäle von der Matte 50 abgewandt sind. Zum Brechen des Kristallkörpers wird ein stumpfer und steifer Gegenstand wie ein Stab verwendet, der unmittelbar auf der Seite des Kristallkörpers mit den Ausnehmungen angelegt wird und mittels dem der Kristallkörper in die Matte hineingedrückt wird.

In der US 5,780,320 ist ein Verfahren zum Brechen eines Wafers beschrieben, bei dem Nuten im Wafer ausgebildet werden. Der Wafer wird derart über einen Brechkeil gezogen, dass die Nuten vom Brechkeil abgewandt sind.

Ausgehend von diesem Stand der Technik liegt der Erfindung die Aufgabe zugrunde, ein Trennverfahren anzugeben, mit dem sich dicke Wafer in Chips mit kleinen Längenabmessungen vereinzeln lassen.

Diese Aufgabe wird durch ein Verfahren mit den Merkmalen von Anspruch 1 gelöst.

Bei dem Verfahren ist ein Rastermaß der Trennungslinie kleiner als die doppelte Dicke des Wafers und der Wafer wird entlang den Trennungslinien mit Ausnehmungen versehen und dann gebrochen.

Durch das Einsägen des Wafers wird die Dicke des Wafers lokal auf das zulässige Maß gebracht. Der Wafer kann dann auf herkömmliche Weise weiter geritzt und gebrochen werden, ohne daß die Gefahr von Ausbrüchen besteht. Das vorgeschlagene Verfahren ermöglicht somit, dicke Wafer in Chips mit kleinen Längenabmessungen zu vereinzeln.

Weitere zweckmäßige Ausgestaltungen der Erfindung sind Gegenstand der abhängigen Ansprüche.

Nachfolgend wird die Erfindung im einzelnen anhand der beigefügten Zeichnungen erläutert. Es zeigen:
- Figur 1: eine schematische Darstellung eines Querschnitts durch einen Wafer, der von der Rückseite eingesägt worden ist; und
- Figur 2: eine schematische Darstellung eines Querschnitts durch den Wafer während des Brechvorgangs.

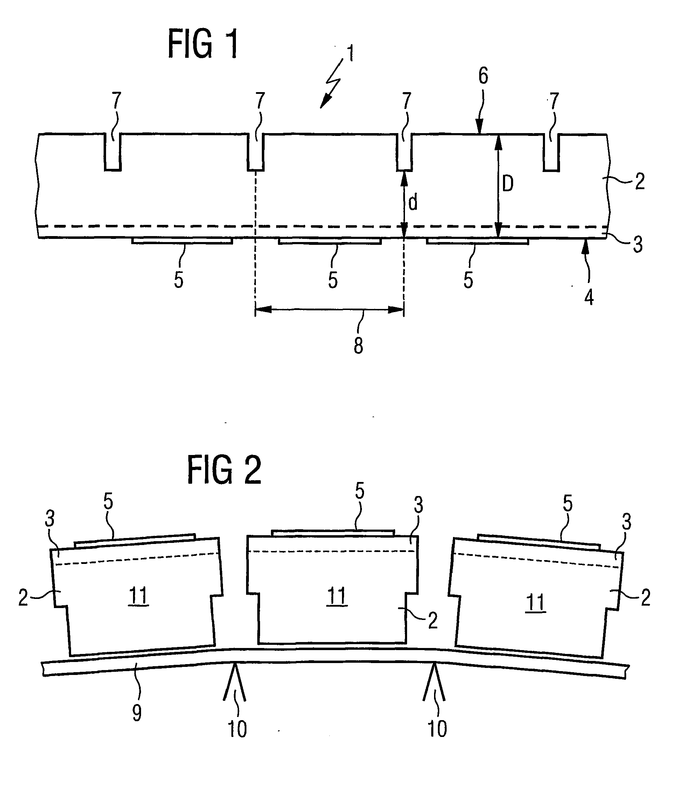

Der in Figur 1 schematisch im Schnitt dargestellte Wafer 1 weist ein Substrat 2 und eine auf diesem Substrat 2 aufgebrachte Epitaxieschicht 3 auf, die aus einer Mehrzahl von nacheinander aufgewachsenen Halbleiterschichten enthält. Die genaue Schichtenfolge hängt von der jeweils vorgesehenen Funktionalität der Epitaxieschicht 3 auf. Das vorliegende Verfahren eignet sich insbesondere zur Anwendung bei der Herstellung von Leuchtdiodenchips. Bei diesen kann die Epitaxieschicht beispielsweise eine eine Einfach-Heterostruktur, eine Doppel-Heterostruktur, eine Single-Quantum-Well-Struktur oder eine Multi-Quantum-Well-Struktur aufweisen. Solche Leuchtdiodenstrukturen sind dem Fachmann auf diesem Gebiet bekannt und werden von daher an dieser Stelle nicht näher erläutert.

Die Dicke des Substrats 2 liegt typischerweise im Bereich von 100 µm. Die Dicke der Epitaxieschicht 3 beträgt typischerweise 10 µm oder weniger. Auf der vom Substrat 2 abgewandten Seite der Epitaxieschicht 3, im Folgenden mit Vorderseite 4 bezeichnet, sind Kontaktstellen 5 ausgebildet. Von einer von der von der Epitaxieschicht 3 abgewandten Rückseite 6 des Substrats 2 her sind in den Wafer 1 schlitzartige Ausnehmungen 7 eingebracht, durch die der Wafer 1 lokal derart geschwächt wird, daß ein Rastermaß 8 der Ausnehmungen 7 größer gleich dem Doppelten der verbleibenden Dicke d des Wafers 1 unter der Ausnehmung 7 ist. Unter Rastermaß ist der jeweilige Abstand zwischen den Mitten von zwei benachbarten Ausnehmungen 7 zu verstehen.

Die Ausnehmungen 7 werden zweckmäßigerweise durch Einsägen hergestellt. Es sei jedoch angemerkt, daß die Ausnehmungen 7 auch durch andere materialabhebende Verfahren, wie beispielsweise Schleifen oder Schneiden mit Hilfe eines Lasers ausgebildet werden können. Es ist auch denkbar, an Stelle der schlitzförmigen Ausnehmungen 7 eine Reihe von in geringem Abstand nebeneinander angeordneten Bohrungen herzustellen.

Nach dem Einbringen der Ausnehmungen 7 auf der Rückseite des Wafers 1 wird der Wafer 1 mit der Substratseite auf eine Trägerfolie 9 aufgebracht (das heißt, die Ausnehmungen sind der Trägerfolie 9 zugewandt) und von der Vorderseite 4 her entsprechend dem Rastermaß 8, das heißt senkrecht gegenüber den Ausnehmungen, geritzt. Anschließend wird der Wafer 1 mit der Trägerfolie 9 derart über Brechkeile 10 gezogen, dass die Trägerfolie 9 den Brechkeilen zugewandt ist, und auf diese Weise zu einzelnen Chips 11 vereinzelt.

Dieses Verfahren ist insbesondere beim Vereinzeln von Wafern 1 von Vorteil, die auf der Basis von III - V - Verbindungshalbleitern wie beispielsweise GaAs oder InP hergestellt sind. Üblicherweise müssen die Längenabmessungen von Chips, das heißt die Länge der parallel zum Wafer verlaufenden Kanten der Chips wenigstens das Doppelte der Dicke des Wafers betragen, um einen weitestgehend fehlerfreien Trennvorgang zu gewährleisten.

Unter dem Begriff Längenabmessungen werden dabei die Rastermaße 8 des Wafers 1, also die Breite oder Länge der aus dem Wafer hergestellten Chips 11 verstanden. Mit dem hier beschriebenen Verfahren lassen sich auch Wafer 1 zu Chips 11 vereinzeln, bei denen die Längenabmessungen kleiner als das Doppelte der Dicke D des Wafers 1 sind. Auch bei diesen im Verhältnis zur Chipgröße großen Dicken D ergeben sich nur geringe Verluste durch Fehler, insbesondere Rückseitenausbrüche, beim Trennvorgang.

Das erfindungsgemäße Verfahren wurde beispielsweise zum Vereinzeln eines Wafers 1 in Chips 11 verwendet, bei denen ein Verhältnis von Längenabmessung zu Dicke D des Wafers 1 von 1,66:1 vorlag. Der Ausbeuteverlust beim Trennprozeß lag in diesem Fall unterhalb von 0,5 %. Ohne die Anwendung der Sägeschlitze 7 lag der Ausbeuteverlust dagegen bei 15 - 20 %.

### Bezugszeichenliste

- 1: Wafer
- 2: Substrat
- 3: Epitaxieschicht
- 4: Vorderseite
- 5: Kontaktstellen
- 6: Rückseite
- 7: Ausnehmungen
- 8: Rastermaß
- 9: Trägerfolie
- 10: Brechkeil
- 11: Chip

## Patentansprüche

1. Verfahren zum Vereinzeln eines Wafers (1) in Chips (11), bei dem der Wafer (1) entlang von Trennungslinien zunächst geschwächt und anschließend entlang den Trennungslinien gebrochen wird, wobei ein Rastermaß (8) der Trennungslinien kleiner als die doppelte Dicke D des Wafers (1) ist und der Wafer (1) entlang der Trennungslinien derart mit Ausnehmungen (7) versehen wird, dass das Verhältnis von Rastermaß zur Restdicke (d) des Wafers im Bereich der Ausnehmungen (7) gleich oder größer 2:1 ist,
**dadurch gekennzeichnet, daß**
der Wafer (1) vor dem Brechen auf eine Trägerfolie (9) derart aufgebracht wird, daß die Ausnehmungen (7) zur Trägerfolie (9) hin gewandt sind und daß der Wafer (1) nachfolgend mit der Trägerfolie (9) derart über mindestens einen Brechkeil (10) gezogen wird, daß die Trägerfolie (9) dem Brechkeil zugewandt ist, und auf diese Weise zu einzelnen Chips (11) vereinzelt wird.

2. Verfahren nach Anspruch 1,
**dadurch gekennzeichnet, daß**
die Ausnehmungen (7) durch Einsägen hergestellt werden.

3. Verfahren nach einem der Ansprüche 1 bis 2,
**dadurch gekennzeichnet, daß**
der Wafer (1) vor dem Vereinzeln mit einer Epitaxieschicht (3) versehen wird.

4. Verfahren nach Anspruch 3,
**dadurch gekennzeichnet, daß**
der Wafer (1) von der der Epitaxieschicht (3) gegenüberliegenden Seite des Wafers (1) her eingesägt wird.

5. Verfahren nach Anspruch 3 oder 4,
**dadurch gekennzeichnet, daß**
der Wafer (1) von der mit der Epitaxieschicht (3) versehenen Vorderseite her vor dem Brechen geritzt wird.

6. Verfahren nach einem der Ansprüche 4 oder 5,
**dadurch gekennzeichnet, daß**
die Epitaxieschicht (3) auf der Basis eines III-V-Verbindungshalbleitermaterials hergestellt ist.

7. Verfahren nach Anspruch 6,
**dadurch gekennzeichnet, daß**
die Epitaxieschicht (3) auf der Basis von GaAs oder InP hergestellt wird.

8. Verfahren nach einem der Ansprüche 1 bis 7,
**dadurch gekennzeichnet, daß**
die entlang den Trennlinien verlaufenen Bruchflächen Spiegelflächen eines Laserresonators sind.

9. Verfahren nach einem der Ansprüche 1 bis 7,
**dadurch gekennzeichnet, daß**
die Epitaxieschicht (3) Leuchtdiodenstrukturen aufweist.

## Claims

1. Method for singulating a wafer (1) into chips (11), in which the wafer (1) is firstly weakened along separation lines and then broken along the separation lines, a grid dimension (8) of the separation lines being less than twice the thickness D of the wafer (1) and the wafer (1) being provided with recesses (7) along the separation lines in such a way that the ratio of grid dimension to the residual thickness (d) of the wafer in the region of the recesses (7) is greater than or equal to 2:1,
**characterized in that**
prior to breaking, the wafer (1) is applied to a carrier sheet (9) in such a way that the recesses (7) face toward the carrier sheet (9), and that the wafer (1) with the carrier sheet (9) is subsequently pulled over at least one breaking wedge (10) in such a way that the carrier sheet (9) faces the breaking wedge, and is singulated into individual chips (11) in this way.

2. Method according to Claim 1,
**characterized in that**
the recesses (7) are produced by being sawn in.

3. Method according to either of Claims 1 and 2,
**characterized in that**
prior to singulation, the wafer (1) is provided with an epitaxial layer (3).

4. Method according to Claim 3,
**characterized in that**
the wafer (1) is sawn from that side of the wafer (1) which is opposite to the epitaxial layer (3).

5. Method according to Claim 3 or 4,
**characterized in that**
prior to breaking, the wafer (1) is scribed from the front side provided with the epitaxial layer (3).

6. Method according to either of Claims 4 and 5,
**characterized in that**
the epitaxial layer (3) is produced on the basis of a III-V compound semiconductor material.

7. Method according to Claim 6,
**characterized in that**
the epitaxial layer (3) is produced on the basis of GaAs or InP.

8. Method according to one of Claims 1 to 7,
**characterized in that**
the breaking areas running along the separating lines are mirror areas of a laser resonator.

9. Method according to one of Claims 1 to 7,
**characterized in that**
the epitaxial layer (3) has light-emitting diode structures.

## Revendications

1. Procédé de découpe d'une galette (1) en puces (11), dans lequel la galette (1) est d'abord amincie le long de lignes de séparation et est ensuite rompue le long des lignes de séparation,
le pas (8) entre les lignes de séparation est inférieur au double de l'épaisseur D de la galette (1) et
la galette (1) est dotée le long des lignes de séparation de découpes (7) de telle sorte que dans la zone de découpe (7), le rapport entre le pas et l'épaisseur résiduelle (d) de la galette soit égal ou supérieur à 2:1, **caractérisé en ce que**
avant la rupture, la galette (1) est appliquée sur une feuille de support (9) en orientant les découpes (7) vers la feuille de support (9) et
**en ce que** la galette (1) est ensuite étendue avec la feuille de support (9) au-dessus d'au moins un biseau de rupture (10) en orientant la feuille de support (9) vers le biseau de rupture et est ainsi découpée en différentes puces (11).

2. Procédé selon la revendication 1, **caractérisé en ce que** les découpes (7) sont formées par sciage.

3. Procédé selon l'une des revendications 1 à 2, **caractérisé en ce qu'**avant la découpe, la galette (1) est dotée d'une couche d'épitaxie.

4. Procédé selon la revendication 3, **caractérisé en ce que** la galette (1) est sciée partant du côté de la galette (1) opposé à la couche d'épitaxie (3).

5. Procédé selon les revendications 3 ou 4, **caractérisé en ce qu'**avant la rupture, la galette (1) est entaillée sur son côté avant doté de la couche d'épitaxie (3).

6. Procédé selon l'une des revendications 4 ou 5, **caractérisé en ce que** la couche d'épitaxie (3) est réalisée en un matériau semi-conducteur de composés III-V.

7. Procédé selon la revendication 6, **caractérisé en ce que** la couche d'épitaxie (3) est réalisée en GaAs ou en InP.

8. Procédé selon l'une des revendications 1 à 7, **caractérisé en ce que** les surfaces de rupture qui s'étendent le long des lignes de séparation sont les surfaces réfléchissantes d'un résonateur laser.

9. Procédé selon l'une des revendications 1 à 7, **caractérisé en ce que** la couche d'épitaxie (3) présente des structures de diode luminescente.
